(19) Europäisches Patentamt / European Patent Office / Office européen des brevets

(11) **EP 4 216 106 A1**

(12) **EUROPEAN PATENT APPLICATION**

(43) Date of publication:
**26.07.2023  Bulletin 2023/30**

(21) Application number: **22152151.1**

(22) Date of filing: **19.01.2022**

(51) International Patent Classification (IPC):
**G06N 3/04** *(2023.01)*    **G06N 3/08** *(2023.01)*
**G03F 7/20** *(2006.01)*

(52) Cooperative Patent Classification (CPC):
**G03F 7/70525; G03F 7/7085; G03F 7/70875;
G03F 7/70891; G06N 3/044; G06N 3/045;
G06N 3/0464; G06N 3/092**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventor: **JIN, Wenjie
5500 AH Veldhoven (NL)**

(74) Representative: **ASML Netherlands B.V.
Corporate Intellectual Property
P.O. Box 324
5500 AH Veldhoven (NL)**

(54) **METHOD FOR CONTROLLING A PRODUCTION SYSTEM AND METHOD FOR THERMALLY CONTROLLING AT LEAST PART OF AN ENVIRONMENT**

(57) A computer-implemented method of generating control actions for controlling a production system, such as by transmitting the control actions to a control system of the production system. The method comprises receiving, by a memory unit, a set of observation data characterizing a current state of the production system; processing, by a first neural network module of the memory unit, an input based on at least part of the observation data to generate encoded observation data; updating, by a second neural network module of the memory unit, history information stored in an internal memory of the second module using an input based on at least part of the observation data; obtaining, based on the encoded observation data and the updated history information, state data; and generating, based on the state data, one or more control actions.

Figure 7

EP 4 216 106 A1

**Description**

FIELD OF THE INVENTION

The present invention relates to a method and a system for controlling a production system, and to a method and a system for thermally controlling at least a part of an environment. More particularly, the present invention relates to a method and a system for controlling a lithographic apparatus.

BACKGROUND OF THE INVENTION

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

It is frequently difficult to maintain a production system such as a lithographic apparatus at its optimum operating conditions. For example, electromagnetic radiation incident on optical surfaces within the lithographic apparatus (e.g. a surface of a mirror or a lens) may cause thermal aberration of those optical surfaces, reducing the performance of the lithographic apparatus. Thermal aberration of this kind may be compensated for by selective heating of the optical surfaces. However, it is difficult to predict - and therefore to control - the occurrence of these aberrations.

Conventionally, conditions within a production system are predicted using mathematical models. This can be done either by constructing a detailed simulation by considering the underlying physics of each component of the production system, or by fitting a simplified mathematical model to observed parameters of the production system.

However, the inherent variation between production systems (due, for example, to differences in the boundary conditions and material properties present in each production system), requires that a detailed simulation model must be calibrated separately on each production system (e.g. on each lithographic apparatus) to the required degree of accuracy. This limits the efficiency with which such models can be deployed.

The simplified mathematical models are fitted to parameters observed for a particular use case (e.g. a certain production system and certain settings of that production system). Therefore, whenever the use case is changed, the simplified model must be re-fitted to the new measured data. Moreover, the simplified model is frequently inaccurate during the period when the production system transitions between one setting and another.

Furthermore, both types of mathematical model are of limited utility if the production system undergoes drift over time (for example, thermal or mechanical drift).

Conventional control systems for controlling properties of an environment (for example, a manufacturing environment or an experimental environment) frequently rely on such mathematical models and are therefore subject to similar limitations.

It is therefore desirable to provide improved control systems which are capable of compensating for variation in production systems and controlled environments.

SUMMARY

It is an object of the present invention to provide new and useful methods and systems for improved control of production systems and environments.

In general terms, a first aspect of the invention proposes a computer-implemented method of generating control actions for controlling a production system, such as by transmitting the control actions to a control system of the production system. The method comprises receiving, by a memory unit, a set of observation data characterizing a current state of the production system; processing, by a first neural network module of the memory unit, an input based on at least part of the observation data to generate encoded observation data; updating, by a second neural network module of the memory unit, history information stored in an internal memory of the second module using an input based on at least part of the observation data; obtaining, based on the encoded observation data and the updated history information, state data; and generating, based on the state data, one or more control actions.

The memory unit may be a component of a computer-implemented adaptive system (that is, a system defined by a plurality of adjustable numerical parameters) which performs the method, and which has been trained (that is, the numerical parameters have been iteratively set) based on training data. The control actions generated by the adaptive system may be transmitted to a control system of the production system to control the production machine. Note that the computer which generates the control actions may in principle be operated by a separate party from the one which operates the production machine. Furthermore, the computer and the production machine may be in separate jurisdictions.

This may provide any of several advantages. The method enables more accurate control of the production system, particularly production systems where the current state of the system depends on the history of the system (for example, a thermal or magnetic history of the system). The presence of the memory unit means that control actions can depend on this history, not just the current state of the machine, and thus be based on a richer data set than sensor data relating only to the current state of the production system. Additionally, the method according to the first aspect of the invention is also capable of improving its own performance over the lifetime of the production system, and of adapting to long-term drift of the production system.

Optionally, generating one or more control actions may comprise determining a parameter value for a subsequent operation of the production system. For example, the control actions, derived from observation data characterizing how the production system produces a first product ("a processing target"), may be used to set a parameter value of the production machine when producing a subsequent product.

The production system may be a semiconductor manufacturing apparatus. The semiconductor manufacturing apparatus may be a lithographic apparatus. However, the invention is not limited in this respect, and the method may be applied to other types of production apparatus.

Optionally, the observation data may be generated from sensor data generated by one or more sensors configured to monitor the production system and/or the processing target. The sensor data may comprise measurements of electromagnetic radiation incident on a processing target of the production system. The processing target may, for example, be a substrate (wafer, e.g. comprising or substantially consisting of semiconductor material) subject to processing (e.g. patterning and/or deposition of one or more additional layers) by the production system. Alternatively or additionally, the sensor data may comprise temperature data obtained from one or more temperature sensors which measure the temperature of one or more locations of the production machine and/or the processing target.

The control system may be configured, based on the control actions, to control a temperature of any part(s) of the production system, e.g. a reticle (mask). However, preferably it is configured to control at least a part of an optical element (e.g. a lens or a mirror) configured to direct electromagnetic radiation to the processing target, thereby enabling the control system to accurately compensate for thermal aberrations of the optical surface. The optical element may include an optical surface which defines a one or more regions, and the one or more control actions may comprise controlling a temperature of each of the regions of the optical surface, enabling the control system to compensate for thermal aberrations in the optical surface more precisely. For example, the control actions may control one of more heaters which selectively direct heat to the regions of the optical surface (e.g. in the form of infrared light directed onto selected one(s) of the regions). This heat can compensate for heat generated by EUV, and so reduce aberrations. Alternatively or additionally, the control actions may control the temperature of a coolant, such as water, which is supplied to the region(s).

Optionally, the sensor data may be processed by a neural network of the adaptive system including at least one convolutional layer to generate the observation data. This enables the dimensions of the observation data to be reduced relative to the dimensions of the sensor data, thereby reducing the computational load on the memory unit.

Optionally, the first neural network module may be a fully connected feed-forward neural network.

Optionally, the second neural network module may be a recurrent neural network.

Optionally, the method may further comprise a step of obtaining at least one dimensionally reduced set of values based on the observation data, and the second neural network module may be configured to update the history information based on one of the dimensionally reduced set of values. This reduces the quantity of data which must be processed by the second neural network module, enhancing the efficiency of the memory unit.

The dimensionally reduced set(s) of values may be obtained by selecting a first (proper) subset of the observation data which is input to the first neural network module, and a second (proper) subset of the observation data which is input to the second neural network module. Optionally, the two subsets of the observation data may be non-overlapping, and they may collectively constitute the whole of the observation data, such that the selection amounts to partitioning the observation data. The selection unit which determines the two subsets may be adaptive, and be trained during the training of the adaptive system comprising the memory unit, so that the second proper subset of data is iteratively changed. Thus, the history information is generated based on the observation data which is most significant for generating the one or more control actions, enabling the performance of the method to be improved, and the training speed and runtime of the method to be reduced. Instead of, or in addition to, generating the dimensionally reduced set(s) of values by selection from the observation data, any data compression method (e.g. any non-linear data compression method) may be used; for example, a non-linear fully connected neural network with fewer output nodes than input nodes could be applied to all, or a sub-set of, the observation data to generate at least one of the dimensionally reduced set(s) of data.

Optionally, the generating, based on the state data, one or more control actions, may comprise: receiving as an input, by a neural network system included in the adaptive system, the state data; and generating, by the neural network system, one or more control actions as an output. The method may further comprise updating the neural network system based on action data comprising a history of control actions generated by the neural network system in response to receiving state data, thereby further enhancing the performance of the method for production systems where the current state of the system depends on the history of the system (for example, a thermal history or magnetic history of the system).

The neural network system may comprise an actor neural network configured to generate the one or more control actions based on the state data, wherein, during the training of the adaptive system, weights of the actor neural network are updated based on (i) a reward value based on the sensor data, and (ii) a quality value output by a critic neural network based on the state data and the action data. Optionally, the actor neural network and critic neural network are trained jointly (that is, with successive updates to the actor neural network and the critic neural network being interleaved, or performed simultaneously) using a deep reinforcement learning procedure. The actor neural network and critic neural network may be trained jointly using a deep deterministic policy gradient procedure, enabling the neural network system to operate effectively over high-dimensional and continuous action spaces. The memory unit may also be trained jointly with the actor neural network and the critic neural network, however it may also be trained separately (e.g. before the actor neural network and critic neural network are trained). The convolutional layer(s), if any, may be trained jointly with the memory unit, or separately.

Where the observation data is generated from sensor data generated by one or more sensors configured to monitor the production system, the sensor data may comprise measurements of electromagnetic radiation incident on a processing target of the production system, and the control system may be configured to control a temperature of at least a part of an optical surface configured to direct the electromagnetic radiation to the processing target. In this case, the reward value may be calculated based on a wavefront error of the electromagnetic radiation measurements, as obtained from the sensor data.

Where the production system is a lithography apparatus, the reward value may be calculated based on one or more measured performance indicators of the production system. The one or more performance indicators may comprise any of a large number of possibilities, such as at least one of: a measured distortion of the wavefront (e.g. after being reflected by the mirror) compared to a predefined wavefront profile, an overlay error, and/or an edge placement error of the lithography apparatus. This enables the performance of the lithography apparatus to be improved.

In general terms, a second aspect of the invention proposes a computer-implemented method of generating control actions for thermally controlling at least a part of an environment. The method comprises: receiving, by a memory unit, a set of observation data characterizing the environment; processing, by a first neural network module of the memory unit, at least part of the observation data to generate encoded observation data; updating, by a second neural network module of the memory unit, history information stored in an internal memory of the second module based on at least part of the observation data; obtaining, based on the encoded observation data and the updated history information, state data; and generating, based on the state data, one or more control actions for a temperature regulation system configured to control the at least a part of the environment.

This may provide any of several advantages. The method enables more accurate thermal control of the environment. Additionally, the method according to the second aspect of the invention is also capable of improving its own performance whilst thermally controlling the environment, and of adapting to long-term drift of the environment.

Optionally, the method may further comprise a step of transmitting the control actions to a temperature regulation system configured to control the at least a part of the environment.

Optionally, the observation data may be generated from sensor data generated by one or more temperature sensors configured to monitor the temperature of corresponding locations of the environment.

Features of the memory unit, the generation of the observation data and the generation of the control actions may be as explained above in relation to the first aspect of the invention.

A third aspect of the invention proposes a computer system comprising a processor and a data storage device, the data storage device storing program instructions which, when executed by the processor, cause the processor to carry out a method according to the first aspect or second aspect of the invention.

A fourth aspect of the invention proposes a computer-readable storage medium comprising instructions which, when executed by a computer, cause the computer to carry out a method according to the first aspect or second aspect of the invention.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4, which is composed of Figure 4(a) and 4(b), shows thermal control of a mirror included in the lithographical apparatus of Figure 1;
- Figure 5 depicts an overview of a method according to a first embodiment of the invention;
- Figure 6 depicts an overview of a method according to a second embodiment of the invention;
- Figure 7 depicts an adaptive system which performs the methods of Figure 4 and 5;
- Figure 8 illustrates the control operation performed by the adaptive system of Figure 7;
- Figure 9 depicts a memory unit of the adaptive system of Figure 7; and
- Figure 10 depicts the training process of a deep reinforcement learning module of the adaptive system of Figure 7.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

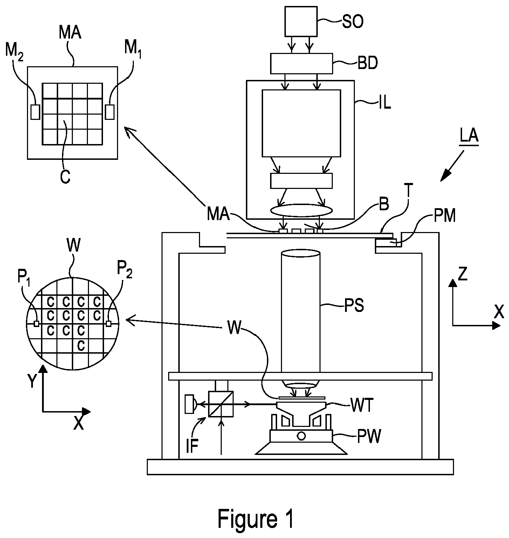

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

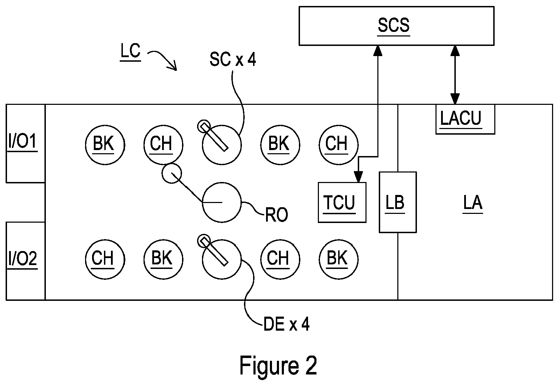

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

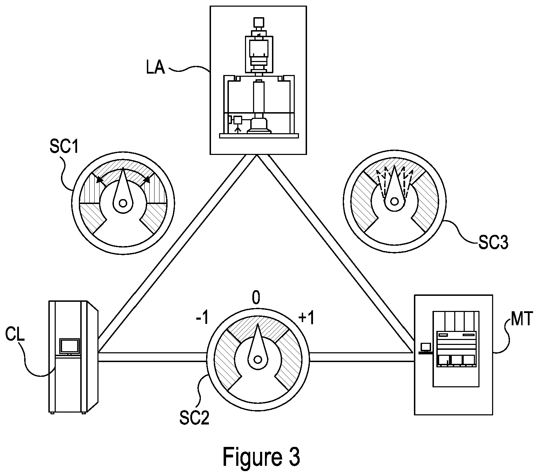

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

The projection system PS of the lithographic apparatus LA may comprise one or more projection optics boxes (POBs), the projection optics boxes being configured to transmit electromagnetic radiation between the patterning device and the target portion C of the substrate W. It has been shown that there is significant variation in values both (a) between different projection optics boxes, and (b) within a given projection optics box over time. Accordingly, improved control systems and methods are required to ensure consistent performance of the lithographic apparatuses LA.

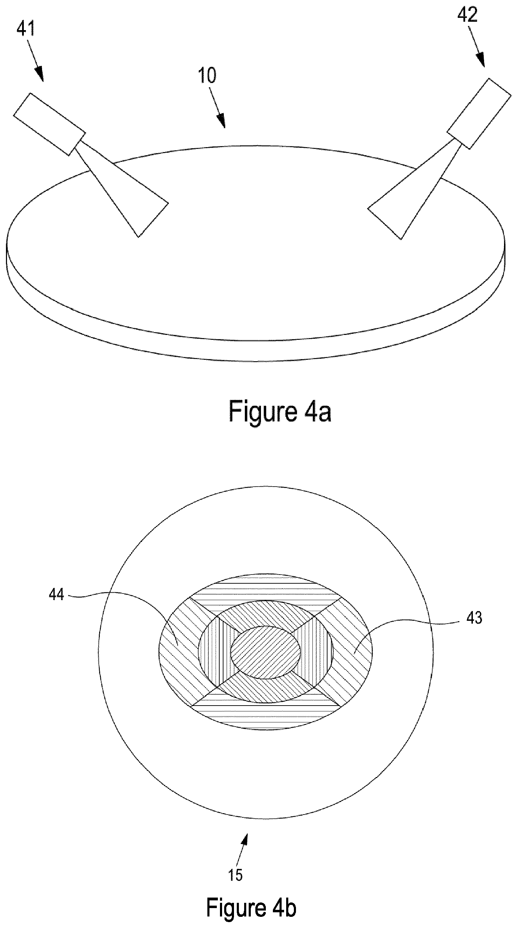

Each of projection optics box contains one or more mirrors 10, one of which is illustrated in Figure 4(a) in perspective view and in Figure 4(b) in top view. The mirror 10 reflects electromagnetic radiation onto a target of the lithographic apparatus, such as a semiconductor wafer. The reflected electromagnetic radiation causes the mirror 10 to deform, resulting in aberration of the mirror 10 and thereby reducing the accuracy of the processing performed by the lithographic apparatus. To compensate for the aberration, each mirror 10 is divided into a plurality of regions 15 indicated in Figure 4(b). The temperature of each region 15 is controllable by varying the power applied to an auxiliary heating means for each region 15. For example, heating systems 41, 42 shown in Figure 4(a) may be provided for heating respectively the regions marked 43 and 44 in Figure 4(b). Additionally, the temperature of each region 15 of the mirror may be controlled by controlling the temperature of a coolant which is used to cool the region 15 of the mirror 10. In the mirror of Figure 4, water is used as the coolant, but in variants of the embodiment other coolants may be implemented. By controlling the thermal deformation of each region of each mirror 10, any aberration of the mirrors 10 due to the reflected electromagnetic radiation can be compensated for.

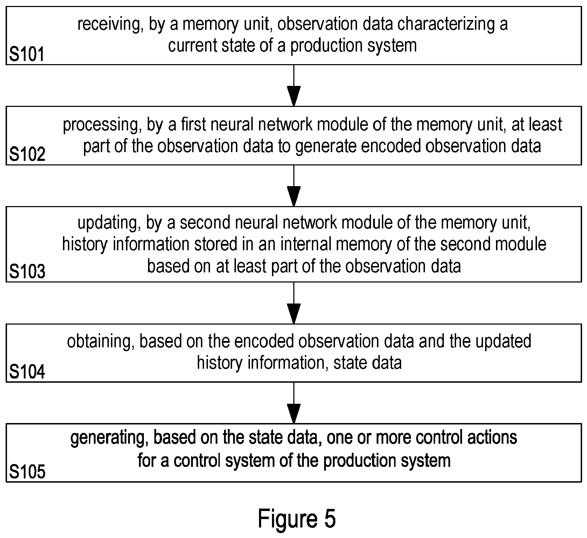

Figure 5 shows an overview of a method for controlling a production system according to a first embodiment of the invention. The production system may be a semiconductor manufacturing apparatus (for example, a lithographic apparatus LA as shown in Figure 1), or another manufacturing apparatus.

In step S101 of the method, observation data $o_t$ characterizing a current state of the production system is received by a memory unit at one of a sequence of times. The times are labelled with by an integer variable t. The observation data $o_t$ may be generated from sensor data generated by one or more sensors configured to monitor the production system. For example, where the production system comprises a lithographic apparatus, the sensor data may comprise measurements of electromagnetic radiation incident on a target of the production system (such as a semiconductor wafer or a patterning device for use in the lithographic apparatus). The sensor data may further comprise one or more temperature measurements generated by one or more temperature sensors configured to monitor the production system.

The observation data $o_t$ may be generated from the sensor data by processing the sensor data by a neural network including at least one convolutional layer. The observation data $o_t$ output by the neural network is then passed to the memory unit as an input.

The memory unit comprises a first neural network module (for example, a fully connected feed-forward neural network) and a second neural network module (for example, a recurrent neural network). The second neural network module comprises an internal memory. Each of the first and second network modules is defined by a respective plurality of numerical values, which can be trained. Thus, the memory unit is a portion of an adaptive system.

In step S102 of the method, the first neural network module receives and processes at least part of the observation data $o_t$ to generate encoded observation data. The first neural network module may process all the received observation data $o_t$, or a sub-set of the observation data $o_t$.

In step S103 of the method, the second neural network module updates history information d stored in the internal memory of the second module based on at least part of the observation data $o_t$. For instance, the memory unit may be configured to obtain a dimensionally reduced set of values $D(o_t)$ based on the observation data $o_t$, and step S103 of the method may comprise updating the history information d based on the dimensionally reduced set of values $D(o_t)$. The updating history information d stored in the internal memory of the second module may comprise replacing the history information $d_{t-1}$ previously stored in the internal memory of the second module with new history information $d_t$. In particular, the updated history information $d_t$ stored in the internal memory may be updated as follows: $d_t = F(d_{t-1}, D(o_t))$, where F is a function defining the processing performed by the second neural network module.

The dimensionally reduced set of values $D(o_t)$ may be obtained from the observation data $o_t$ by excluding from the observation data $o_t$ one or more components of the observation data $o_t$ which are conditionally independent of the history information. For example, the received observation data $o_t$ may be passed to a linear neural network layer of the memory unit, the observation data $o_t$ being multiplied by a matrix A of weights of size K x N, where N is the number of observation variables and K is an integer hyperparameter (less than N) that determines the dimensions of the output. In other words, the dimensionally reduced set of values $D(o_t)$ may be obtained from observation data $o_t$ as follows: $D(o_t) = Ao_t$.

If A is constrained such that each column of A contains only one non-zero weight, and that non-zero weight is 1, then $D(o_t)$ is a proper subset of $o_t$. Optionally, the input to the first neural network in step S102 may be the component(s) of $o_t$ which are excluded from $o_t$ by this operation (i.e. the observation data $o_t$ is partitioned into two (proper) subsets which are respectively (i) the input to the first neural network module and (ii) the input to second neural network module, which is $D(o_t) = Ao_t$).

However, the dimensional reduction operation is not limited in this way; for example, A may take any form. Similarly the data input to the first neural network module in step S 102 may be generated in any way from $o_t$, preferably in a way which reduces its dimensionality. For example, $D(o_t)$ may be obtained by any data compression method (e.g. any non-linear data compression method). For example, $D(o_t)$ may be output from a non-linear fully connected neural network (e.g. with fewer output nodes than input nodes), which receives all, or a sub-set of, the observation data. Optionally, $D(o_t)$ could be the output from some of the output layer notes of the neural network, and the data input to the first neural network module in step S102 may be the output from other output layer nodes of the neural network.

In step S 104 of the method, state data is obtained based on the encoded observation data and the updated history information $d_t$. The state data may be obtained by concatenating the encoded observation data with the updated history information $d_t$.

In step S 105 of the method, one or more control actions for a control system of the production system are generated based on the state data. The one or more control actions may be generated by a neural network system configured to receive the state data as an input and generate the one or more control actions as an output. The control actions generated may then be transmitted to the production system.

During training, the weights of the neural network system may be updated based on action data comprising a history of control actions generated by the neural network system in response to receiving state data. The neural network system may comprise an actor neural network configured to generate the one or more control actions based on the state data, and during training of the actor neural network weights of the actor neural network may be updated based on (i) a reward value based on the sensor data, and (ii) a quality value output by a critic neural network based on the state data and the action data. The actor neural network may generate the one or more control actions from the state data based on a policy learned during training of the actor neural network. The actor neural network and critic neural network may be trained jointly using a deep reinforcement learning - for example, a deep deterministic policy gradient procedure. In particular, the actor neural network and critic neural network may be trained jointly using a Twin Delayed Deep Deterministic policy gradient (TD3) procedure.

In a TD3 procedure, two critic neural networks are implemented during the training of the actor neural network, each critic neural network being configured to generate a quality value based on the state data and the action data. During the training process, the weights of the actor neural network and the weights of each critic neural network are updated based on a target value calculated using the minimum quality value output by the two critic neural networks. Random noise may also be added to the target value before the weights are updated.

Training of the neural network system may continue during deployment of the neural network system with a particular production system, enabling the neural network system to continuously adapt to variation in the production system. Similarly, training of the first neural network module and second neural network module may continue during deployment of the memory unit, enabling the memory unit to continuously adapt to variation in the production system.

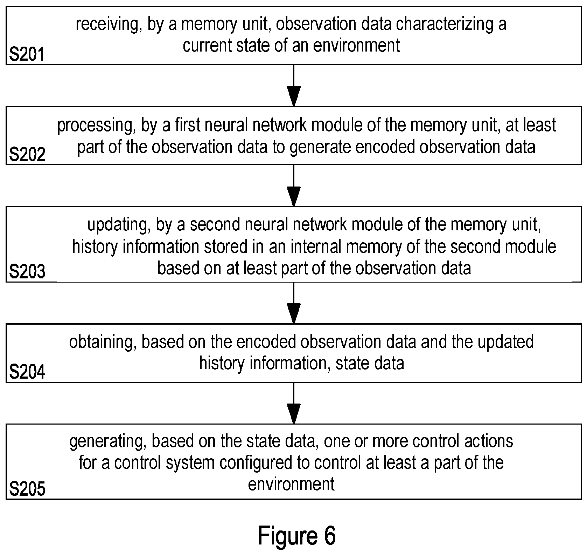

Figure 6 shows an overview of a method for thermally controlling at least a part of an environment according to a second embodiment of the invention. The environment controlled by the method of Figure 5 may be, for example, a manufacturing environment, a laboratory, or a storage facility.

In step S201 of the method, observation data $o_t$ characterizing a current state of the environment is received by a memory unit. The observation data $o_t$ may be generated from sensor data generated by one or more temperature sensors configured to monitor the temperature of corresponding locations of the environment.

The observation data $o_t$ may be generated from the sensor data by processing the sensor data by a neural network including at least one convolutional layer. The observation data $o_t$ output by the neural network is then passed to the memory unit as an input.

The memory unit comprises a first neural network module (for example, a fully connected feed-forward neural network) and a second neural network module (for example, a recurrent neural network). The second neural network module comprises an internal memory.

In step S202 of the method, the first neural network module processes at least part of the observation data $o_t$ to generate encoded observation data. The first neural network module may process all the received observation data $o_t$, or a sub-set of the observation data $o_t$.

In step S203 of the method, the second neural network module updates history information d stored in the internal memory of the second module based on at least part of the observation data $o_t$. For instance, the memory unit may be configured to obtain a dimensionally reduced set of values $D(o_t)$ based on the observation data $o_t$, and step S203 of the method may comprise updating the history information d based on the dimensionally reduced set of values $D(o_t)$. The updating history information d stored in the internal memory of the second module may comprise replacing the history information $d_{t-1}$ previously stored in the internal memory of the second module with new history information $d_t$. In particular, the updated history information $d_t$ stored in the internal memory may be updated as follows: $d_t = F(d_{t-1}, D(o_t))$, where F is a function defining the processing performed by the second neural network module.

The dimensionally reduced set of values $D(o_t)$ may be obtained from the observation data $o_t$ by excluding from the observation data $o_t$ one or more components of the observation data $o_t$ which are conditionally independent of the history information. For example, the received observation data $o_t$ may be passed to a linear neural network layer of the memory unit, the observation data $o_t$ being multiplied by a matrix A of weights of size K x N, where N is the number of observation variables and K is a hyperparameter that determines the dimensions of the output. In other words, the dimensionally reduced set of values $D(o_t)$ may be obtained from observation data $o_t$ as follows: $D(o_t) = Ao_t$. The weights of the matrix A may be learned during training of the memory unit.

In step S204 of the method, state data is obtained based on the encoded observation data and the updated history information $d_t$. The state data may be obtained by concatenating the encoded observation data with the updated history information $d_t$.

In step S205 of the method, one or more control actions for a control system configured to control at least a part of the environment are generated based on the state data. The one or more control actions may be generated by a neural network system configured to receive the state data as an input and generate the one or more control actions as an output. The generated control actions may be transmitted to a temperature regulation system configured to control the at least a part of the environment.

During training, the weights of the neural network system may be updated based on action data comprising a history of control actions generated by the neural network system in response to receiving state data. The neural network system may comprise an actor neural network configured to generate the one or more control actions based on the state data, and during training of the actor neural network weights of the actor neural network may be updated based on (i) a reward value based on the sensor data, and (ii) a quality value output by a critic neural network based on the state data and the action data. The actor neural network may generate the one or more control actions from the state data based on a policy learned during training of the actor neural network. The actor neural network and critic neural network may be trained jointly using a deep reinforcement learning - for example, a deep deterministic policy gradient procedure. In particular, the actor neural network and critic neural network may be trained jointly using a Twin Delayed Deep Deterministic policy gradient (TD3) procedure.

In a TD3 procedure, two critic neural networks are implemented during the training of the actor neural network, each critic neural network being configured to generate a quality value based on the state data and the action data. During the training process, the weights of the actor neural network and the weights of each critic neural network are updated based on a target value calculated using the minimum quality value output by the two critic neural networks. Random noise may also be added to the target value before the weights are updated.

Training of the neural network system may continue during deployment of the neural network system in a particular environment, enabling the neural network system to continuously adapt to variation in the environment. Similarly, training of the first neural network module and second neural network module may continue during deployment of the memory unit, enabling the memory unit to continuously adapt to variation in the environment.

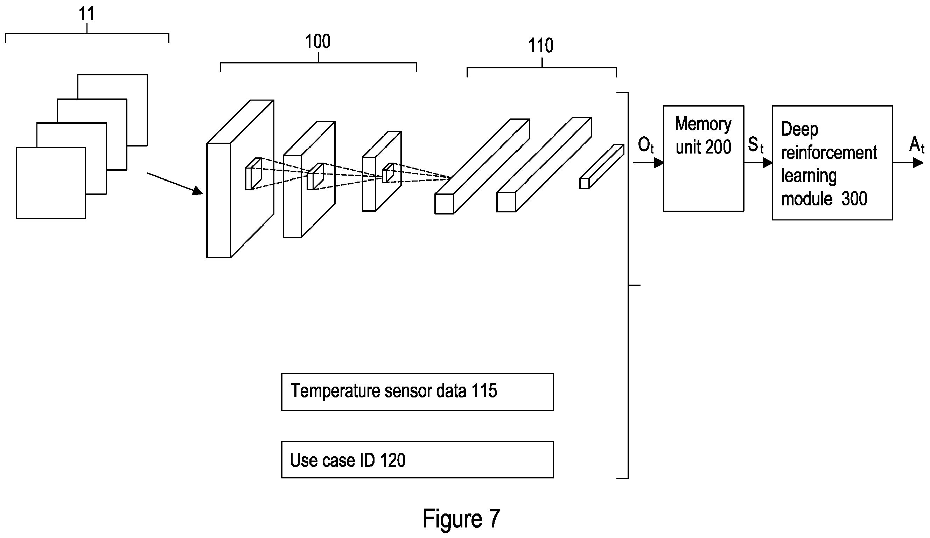

Figure 7 shows the operation of an adaptive system which performs a method according to both Figure 4 and Figure 5, and which is itself an embodiment of the invention. The operation is depicted at a time t, which is one of a sequence of times. In the embodiment of Figure 6, the memory unit (denoted 200 in figure 7) is configured to receive observation data characterizing a state of a production system which is a lithographic apparatus comprising an optical assembly.

At each time step t, the electromagnetic radiation incident on the target of the lithographic apparatus is measured, generating wavefront data 11. This may for example include a plurality of 128x128 pixel data arrays. In the embodiment of Figure 6, the electromagnetic radiation is measured using an integrated lens interferometer arrangement, but in variants of the embodiment other sensors may be used to detect the electromagnetic radiation. The temperature of one or more regions of the mirror 10 is monitored using a corresponding temperature sensor. Note that the regions of the mirror which the temperature sensors monitor may not be the regions 15 which are heated (e.g. temperature sensors may be provided for some of the regions 15, but not provided for others). The outputs of the temperature sensors are merely optional inputs to the control system. Furthermore, the control system may alternatively or additionally receive temperate inputs from other regions in the lithographic apparatus, such as regions on the wafer table and/or the reticle.

The wavefront data 11 are then encoded into a one-dimensional array by a neural network 100 comprising at least one convolutional layer. The output of the convolutional neural network 100 is then passed through a fully-connected neural network layer 110.

The encoded wavefront data are then optionally concatenated with the measured temperature data 115, and/or with past use case data 120 identified by one or more use case IDs, to obtain a set of observation data $o_t$. In variants of the embodiment, the observation data $o_t$ may be obtained based on the wavefront data 11 and temperature data 115 only.

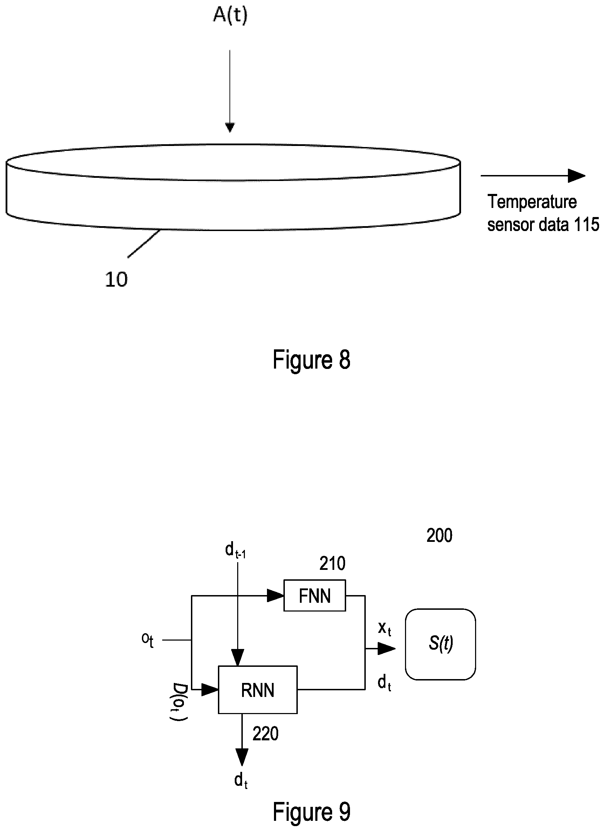

The observation data $o_t$ is then received by the memory unit 200. As shown in Figure 9, the memory unit 200 comprises a first neural network module 210 which is a fully-connected feed-forward neural network (FNN), and a second neural network module 220 which is a recurrent neural network (RNN). The recurrent neural network comprises an internal memory (not shown).

The first neural network module 210 is configured to process the received observation data $o_t$ to generate encoded observation data xt. The first neural network 210 may process all the received observation data $o_t$, or a subset of the observation data $o_t$.

Based on the received observation data $o_t$, the memory unit 200 is configured to generate a set of dimensionally reduced set of values $D(o_t)$. The dimensionally reduced set of values $D(o_t)$ may be obtained from the observation data $o_t$ by excluding from the observation data $o_t$ one or more components of the observation data $o_t$. For example, the received observation data $o_t$ may be passed to a linear neural network layer (not shown) of the memory unit 200, the observation data $o_t$ being multiplied by a matrix A of weights of size K x N, where N is the number of observation variables and K is a hyperparameter that determines the dimensions of the output. In other words, the dimensionally reduced set of values $D(o_t)$ may be obtained from observation data $o_t$ as follows: $D(o_t) = Ao_t$. The weights of the matrix A may be learned during training of the memory unit 200.

The updating of history information $d_{t-1}$ stored in the internal memory of the second neural network module 220 may comprise replacing the history information $d_{i-1}$ previously stored in the internal memory of the second neural network module 220 with new history information $d_t$ derived using the dimensionally reduced set of values $D(o_t)$. In particular, the updated history information $d_t$ stored in the internal memory may be updated as follows: $d_t = F(d_{t-1}, D(o_t))$, where F is a function defining the mapping between the input and the output of the second neural network module 220. The second neural network module 220 outputs the updated history information, and also stores it for use in the next iteration.

The encoded observation data $x_t$ output by the first neural network module 210 are then concatenated with the updated history information $d_t$ output by the second neural network module 220 to generate state data S(t).

At each time step t, a neural network system 300, referred to as a deep reinforcement learning module, is configured to receive the state data S(t) generated by the memory unit 200, and generate action data A(t). As illustrated in Figure 8, the control actions generated A(t) by the neural network system 300 may then be transmitted to the lithographic apparatus LA, and used to control the temperature control system of the mirror 10, so as to control the temperature of the mirror. The memory unit 200 is of great value since it means that the actions A(t) can not only depend on the current state of the production system but also on the thermal history of the production system (e.g. the mirror 10), i.e. the production system's previous states.

During the implementation of these control actions, or subsequently, sensor data obtained from the lithographic apparatus is used to calculate a reward value R(t). The reward value R(t) may be calculated based on one or more of the following, which can be derived from the sensor data: a wavefront error of the electromagnetic radiation measurements 11, an overlay error of the lithographic apparatus, and an edge placement error of the lithographic apparatus. An overlay error of the lithographic apparatus may be calculated based on a displacement between one or more pattern layers in a semiconductor wafer during the patterning process. The one or more pattern layers need not be adjacent pattern layers. When the reward value R(t) is based on at least one of the overlay error of the lithographic apparatus and the edge placement error of the lithographic apparatus, the quality of semiconductor processing may be thereby improved. In variants of the embodiment, other performance indicators of the lithographic apparatus may be substituted for the overlay error and/or edge placement error when calculating the reward value R(t). Additionally, further temperature sensor data 115 is collected for use in the next time step, to generate the next state data S(t+1).

The memory unit 200, the convolutional neural network 100 and the fully-connected neural network layer 110 may be trained (jointly, or separately, e.g. one after another) before training the neural network system 300. If so they may be frozen (i.e. not changed) during the training of the neural network system 300. Note that during the joint or separate training of the convolutional network 100, fully-connected neural network layer 100 and the memory unit 200, control model(s) are used to judge the present quality of these units, but these control model(s) can be much simpler than the neural network system 300, e.g. to focus more computational efforts on the memory unit.

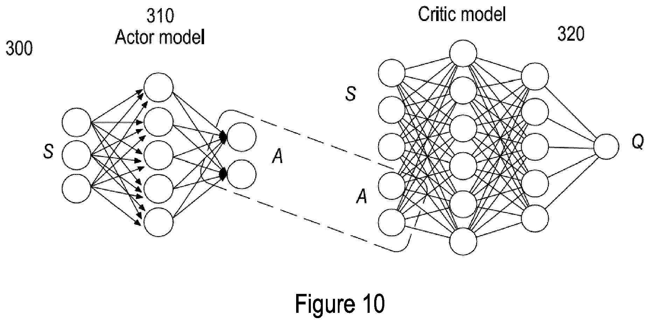

Figure 10 illustrates the structure of the neural network system 300 within the overall adaptive system of Figure 7. As shown in Figure 10, the neural network system 300 comprises an actor neural network 310 and a critic neural network 320. The actor neural network 310 is configured to receive the state data S(t) output by the memory unit 200, and to generate action data A(t) from the state data S(t) based on a policy learned during training of the actor neural network 310. The actor neural network generates the action A, i.e. it maps S(t) to A(t). At time t, the critic neural network 320 maps S(t) and A(t) to a quality value Q(t). Similarly, at time t+1, the critic neural network 320 maps S(t+1) and A(t+1) to a quality value Q(t+1).

The training of the neural network system 300 is done using a library of data referred to as a dynamic replay memory, including a number of data tuples, each having four elements:

$$S(t), A(t), S(t+1), R(t)$$

$$S(t+1), A(t+1), S(t+2), R(t+1), \text{etc.}$$

During training of the neural network system 300, weights of the actor neural network 310 are updated based on (i) the reward value R based on the sensor data, and (ii) a quality value Q output by the critic neural network 320 based on the state data S and the action data A. In the embodiment shown, the actor network 310 and critic neural network 320 are jointly trained using a deep reinforcement learning procedure. In the embodiment of Figure 7, the weights of the actor neural network 310 and critic neural network 320 are alternately frozen and updated during training of the neural network system 300. In particular, the actor neural network 310 is trained using a deep deterministic policy gradient procedure. In one form the training proceeds by defining a value Q_target as

$$Q\_target(t) = R(t) + yQ(t+1)$$

where y is a hyperparameter. The critic model can then be updated by backpropagation to minimize a mean square error (MSE) loss defined as MSE_Loss (Q(t),Q_target(t)). The actor neural network 310 is then updated, without changing the critic neural network 310, by backpropagation to maximize (Q(t)).

In variants of the embodiment, the actor network 310 may be trained using a Twin Delayed Deep Deterministic policy gradient (TD3) procedure.

In a TD3 procedure, two critic neural networks 320 are implemented during the training of the actor neural network 310, each critic neural network 320 being configured to generate a quality value $Q_i$ based on the state data S and the action data A. During the training process, the weights of the actor neural network 310 and the weights of each critic neural network 320 are updated based on a target value calculated using the minimum quality value $Q_i$ output by the two critic neural networks 320. Random noise may also be added to the target value before updating the weights of the actor neural network 310 and critic neural networks 320.

Optionally, the neural network system 300 may have an initial training phase using data generated based on training data obtained from a lithographic apparatus other than the one it is intended to eventually control, or from a physical model of the production system.

Training of the neural network system 300 may alternatively be carried out, or may continue, during deployment of the neural network system 300 with a particular lithographic apparatus, enabling the neural network system 300 to continuously adapt to variation in the projection optics box. Similarly, training of the first neural network module 210 and second neural network module 220 may continue during deployment of the memory unit 200, enabling the memory 200 unit to continuously adapt to variation in the projection optics box.

Further embodiments of the invention are disclosed in the list of numbered clauses below:

1. A computer-implemented method of generating one or more control actions for controlling a production system, the method comprising:

receiving, by a memory unit, observation data characterizing a current state of the production system;
processing, by a first neural network module of the memory unit, an input to the first neural network module which is based on at least part of the observation data, to generate encoded observation data;
updating, by a second neural network module of the memory unit, history information stored in an internal memory of the second neural network module using an input to the second neural network module which is based on at least part of the observation data;
obtaining, based on the encoded observation data and the updated history information, state data; and
generating, based on the state data, one or more control actions for a control system of the production system.

2. The method according to clause 1, further comprising a step of transmitting the control actions to the control system of the production system.

3. The method according to clause 1 or clause 2, wherein generating one or more control actions comprises determining a parameter value for a subsequent operation of the production system.

4. The method according to any of clauses 13, wherein the production system is a semiconductor manufacturing apparatus.

5. The method according to clause 4, wherein the semiconductor manufacturing apparatus is a lithographic apparatus.

6. The method according to any preceding clause, in which the observation data is generated from sensor data generated by one or more sensors configured to monitor the production system.

7. The method according to clause 6, wherein the sensor data comprises measurements of electromagnetic radiation incident on a processing target of the production system.

8. The method according to clause 7, wherein the processing target is provided to a substrate subject to processing by the production system.

9. The method according to any preceding clause, wherein the control system is configured to control a temperature of at least part of the production system.

10. The method according to clause 9, wherein the control system is configured to control a temperature of at least part of a reticle used in the production system.

11. The method according to clause 7 or clause 8, in which the control system is configured to control an optical element configured to direct the electromagnetic radiation to the processing target.

12. The method according to clause 11, wherein the optical element includes an optical surface including a plurality of regions, and the one or more control actions comprise controlling a temperature of each of the regions of the optical surface.

13. The method according to clause 12, wherein the optical element is a mirror or a lens.

14. A computer-implemented method of generating one or more control actions for thermally controlling at least part of an environment, the method comprising:

receiving, by a memory unit, observation data characterizing the environment;
processing, by a first neural network module of the memory unit, an input to the first neural network module which is based on at least part of the observation data to generate encoded observation data;
updating, by a second neural network module of the memory unit, history information stored in an internal memory of the second module using an input to the second neural network module which is based on at least part of the observation data;
obtaining, based on the encoded observation data and the updated history information, state data; and
generating, based on the state data, one or more control actions for a temperature regulation system configured to control the at least part of the environment.

15. The method according to clause 14, further comprising a step of transmitting the control actions to a temperature regulation system configured to control the at least part of the environment.

16. The method according to clause 14 or clause 15, in which the observation data is generated from sensor data generated by one or more temperature sensors configured to monitor the temperature of corresponding locations of the environment.

17. The method according to any of clauses 6-11 or 16, wherein the sensor data is processed by a neural network including at least one convolutional layer to generate the observation data.

18. The method according to any preceding clause, wherein the first neural network module of the memory unit is a fully connected feed-forward neural network.

19. The method according to any preceding clause, wherein the second neural network module of the memory unit is a recurrent neural network.

20. The method according to any preceding clause, the method further comprising a step of obtaining one or more dimensionally reduced sets of values based on the observation data, and wherein the input to the second neural network module of the memory unit is one of the dimensionally reduced sets of values.

21. The method according to clause 20 in which the dimensionally reduced sets of values are obtained by selecting a first subset of the observation data which is the input to the first neural network module, and a second subset of the observation data which is the input to the second neural network module .

22. The method according to any preceding clause, wherein the generating, based on the state data, one or more control actions, comprises:

receiving as an input, by a neural network system, the state data; and
generating, by the neural network system, one or more control actions as an output.

23. The method according to clause 22, further comprising updating the neural network system based on action data comprising a history of control actions generated by the neural network system in response to receiving state data.

24. The method according to clause 23, when dependent on clause 6, wherein the neural network system comprises an actor neural network configured to generate the one or more control actions based on the state data, wherein weights of the actor neural network are updated based on (i) a reward value based on the sensor data, and (ii) a quality value output by a critic neural network based on the state data and the action data.

25. The method according to clause 24, wherein the actor neural network and critic neural network are trained jointly using a deep reinforcement learning procedure.

26. The method according to clause 25, wherein the deep reinforcement learning procedure is a deep deterministic policy gradient procedure.

27. The method according to any of clauses 24-26 when dependent upon clause 7, wherein the reward value is calculated based on a wavefront error of the electromagnetic radiation measurements.

28. The method according to any of clauses 24-27 when dependent upon clause 5, wherein the reward value is calculated based on one or more performance indicators of the lithography apparatus.

29. The method according to clause 28 wherein the one or more performance indicators comprise at least one of: an overlay error and an edge placement error of the lithography apparatus.

30. A computer system comprising a processor and a data storage device, the data storage device storing program instructions which, when executed by the processor, cause the processor to carry out the method of any preceding clause.

31. A computer-readable storage medium comprising instructions which, when executed by a computer, cause the computer to carry out the method of any of clauses 1 to 29.

The method according to any of the above-described embodiments may be implemented on the computer system CL, or on any other suitable computer system. The computer system may be a computer system comprising a processor and a data storage device, the data storage device storing program instructions which, when executed by the processor, cause the processor to carry out the method of any of the above-described embodiments. Embodiments of the subject-matter described in this specification may also be implemented using a computer-readable storage medium comprising instructions which, when executed by a computer, cause the computer to carry out the method according to any of the above-described embodiments.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A computer-implemented method of generating one or more control actions for controlling a production system, the method comprising:

receiving, by a memory unit, observation data characterizing a current state of the production system;
processing, by a first neural network module of the memory unit, an input to the first neural network module which is based on at least part of the observation data, to generate encoded observation data;
updating, by a second neural network module of the memory unit, history information stored in an internal memory of the second neural network module using an input to the second neural network module which is based on at least part of the observation data;
obtaining, based on the encoded observation data and the updated history information, state data; and
generating, based on the state data, one or more control actions for a control system of the production system.

2. The method according to claim 1, in which the observation data is generated from sensor data generated by one or more sensors configured to monitor the production system.

3. The method according to claim 2, wherein the sensor data is processed by a neural network including at least one convolutional layer to generate the observation data.

4. The method according to any preceding claim, wherein the first neural network module of the memory unit is a fully connected feed-forward neural network.

5. The method according to any preceding claim, wherein the second neural network module of the memory unit is a recurrent neural network.

6. The method according to any preceding claim, the method further comprising a step of obtaining one or more dimensionally reduced sets of values based on the observation data, and wherein the input to the second neural network module of the memory unit is one of the dimensionally reduced sets of values.

7. The method according to claim 6 in which the dimensionally reduced sets of values are obtained by selecting a first subset of the observation data which is the input to the first neural network module, and a second subset of the observation data which is the input to the second neural network module .

8. The method according to any preceding claim, wherein the generating, based on the state data, one or more control actions, comprises:

receiving as an input, by a neural network system, the state data; and
generating, by the neural network system, one or more control actions as an output.

9. The method according to claim 8, further comprising updating the neural network system based on action data comprising a history of control actions generated by the neural network system in response to receiving state data.

10. The method according to claim 9, when dependent on claim 2 or 3, wherein the neural network system comprises an actor neural network configured to generate the one or more control actions based on the state data, wherein weights of the actor neural network are updated based on (i) a reward value based on the sensor data, and (ii) a quality value output by a critic neural network based on the state data and the action data.

11. The method according to claim 10, wherein the actor neural network and critic neural network are trained jointly using a deep reinforcement learning procedure.

12. The method according to claim 11, wherein the deep reinforcement learning procedure is a deep deterministic policy gradient procedure.

13. The method according to any of claims 10 to 12, wherein the reward value is calculated based on one or more performance indicators of the production system.

14. The method according to claim 13 wherein production system is a lithographic apparatus and the one or more performance indicators comprise at least one of: an overlay error and an edge placement error of the lithography apparatus.

15. A computer system comprising a processor and a data storage device, the data storage device storing program instructions which, when executed by the processor, cause the processor to carry out the method of any preceding claim.

Figure 1

Figure 2

Figure 3

41

10

42

## Figure 4a

44

43

15

## Figure 4b

S101 | receiving, by a memory unit, observation data characterizing a current state of a production system

S102 | processing, by a first neural network module of the memory unit, at least part of the observation data to generate encoded observation data

S103 | updating, by a second neural network module of the memory unit, history information stored in an internal memory of the second module based on at least part of the observation data

S104 | obtaining, based on the encoded observation data and the updated history information, state data

S105 | generating, based on the state data, one or more control actions for a control system of the production system

Figure 5

S201 | receiving, by a memory unit, observation data characterizing a current state of an environment

S202 | processing, by a first neural network module of the memory unit, at least part of the observation data to generate encoded observation data

S203 | updating, by a second neural network module of the memory unit, history information stored in an internal memory of the second module based on at least part of the observation data

S204 | obtaining, based on the encoded observation data and the updated history information, state data

S205 | generating, based on the state data, one or more control actions for a control system configured to control at least a part of the environment

Figure 6

Figure 7

Temperature sensor data 115

Use case ID 120

Memory unit 200

Deep reinforcement learning module 300

$O_t$

$S_t$

$A_t$

11

100

110

EP 4 216 106 A1

A(t)

Temperature
sensor data 115

10

Figure 8

200

d$_{t-1}$

210

FNN

o$_t$

x$_t$

$S(t)$

$D(o_t)$

RNN

d$_t$

220

d$_t$

Figure 9

Figure 10

Europäisches Patentamt
European Patent Office
Office européen des brevets

**Application Number**

EP 22 15 2151

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/008174 A1 (ASML NETHERLANDS BV [NL]) 13 January 2022 (2022-01-13) * abstract; claims 1-20; figures 1-14 * * paragraph [0002] – paragraph [00071] * * paragraph [00073] – paragraph [000205] * | 1-15 | INV. G06N3/04 G06N3/08 G03F7/20 |
| A | WO 2020/094325 A1 (ASML NETHERLANDS BV [NL]) 14 May 2020 (2020-05-14) * abstract; claims 1-15; figures 1-17 * * paragraph [0003] * | 1-15 | |
| A | WO 2021/197717 A1 (ASML NETHERLANDS BV [NL]) 7 October 2021 (2021-10-07) * abstract; claims 1-14; figures 1-4 * * paragraph [0002] – paragraph [00056] * * paragraph [00058] – paragraph [000129] * | 1-15 | |

TECHNICAL FIELDS SEARCHED (IPC)

G03F
G06N

The present search report has been drawn up for all claims

| Place of search | Date of completion of the search | Examiner |
|---|---|---|
| The Hague | 4 July 2022 | Totir, Felix |

## ANNEX TO THE EUROPEAN SEARCH REPORT
## ON EUROPEAN PATENT APPLICATION NO.

EP 22 15 2151

This annex lists the patent family members relating to the patent documents cited in the above-mentioned European search report.
The members are as contained in the European Patent Office EDP file on
The European Patent Office is in no way liable for these particulars which are merely given for the purpose of information.

04-07-2022

| Patent document cited in search report | | Publication date | Patent family member(s) | | Publication date |
|---|---|---|---|---|---|
| WO 2022008174 | A1 | 13-01-2022 | TW | 202209095 A | 01-03-2022 |
| | | | WO | 2022008174 A1 | 13-01-2022 |
| WO 2020094325 | A1 | 14-05-2020 | CN | 112969967 A | 15-06-2021 |
| | | | EP | 3807720 A1 | 21-04-2021 |
| | | | EP | 3974906 A1 | 30-03-2022 |
| | | | JP | 2022511681 A | 01-02-2022 |
| | | | KR | 20210069104 A | 10-06-2021 |
| | | | TW | 202025329 A | 01-07-2020 |
| | | | TW | 202101633 A | 01-01-2021 |
| | | | TW | 202135196 A | 16-09-2021 |
| | | | US | 2021165399 A1 | 03-06-2021 |
| | | | US | 2021333785 A1 | 28-10-2021 |
| | | | WO | 2020094325 A1 | 14-05-2020 |
| WO 2021197717 | A1 | 07-10-2021 | TW | 202205026 A | 01-02-2022 |
| | | | WO | 2021197717 A1 | 07-10-2021 |

EPO FORM P0459

For more details about this annex : see Official Journal of the European Patent Office, No. 12/82

**EP 4 216 106 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B